# EUROPÄISCHE PATENTANMELDUNG

(11) **EP 4 012 762 A1**
(43) Veröffentlichungstag der Anmeldung: **15.06.2022**
(21) Anmeldenummer: 20212842.7
(22) Anmeldetag: 09.12.2020
(51) Int. Cl.: H01L 23/367, H01L 23/427, H01L 23/498, H01L 23/538, H05K 7/20

(54) **HALBLEITERMODUL MIT ZUMINDEST EINEM HALBLEITERELEMENT**

(71) Anmelder: Siemens Aktiengesellschaft, 80333 München (DE)
(72) Erfinder: Pfefferlein, Stefan, 90562 Heroldsberg (DE); Werner, Ronny, 90419 Nürnberg (DE)

(57) **Zusammenfassung**

Die Erfindung betrifft ein Halbleitermodul (2) mit zumindest einem Halbleiterelement (4), einem ersten Substrat (6) und einem zweiten Substrat (12). Um, im Vergleich zum Stand der Technik, eine höhere Zuverlässigkeit zu erreichen, wird vorgeschlagen, dass das zumindest eine Halbleiterelement (4) auf einer ersten Seite (6) flächig mit dem ersten Substrat (8) und auf einer der ersten Seite (6) abgewandten zweiten Seite (10) flächig mit dem zweiten Substrat (12) verbunden ist, wobei ein Phasenwechselmaterial (30) in einer geschlossenen, insbesondere zusammenhängenden, Hohlraumstruktur (44) des zweiten Substrats (12) angeordnet ist und mit dem Halbleiterelement (4) in einer thermisch leitenden Verbindung steht.

## Beschreibung

Die Erfindung betrifft ein Halbleitermodul mit zumindest einem Halbleiterelement.

Ferner betrifft die Erfindung einen Stromrichter mit mindestens einem derartigen Halbleitermodul.

Darüber hinaus betrifft die Erfindung ein Verfahren zur Herstellung eines Halbleitermoduls mit zumindest einem Halbleiterelement.

Derartige Halbleitermodule kommen in der Regel in einem Stromrichter zum Einsatz. Unter einem Stromrichter ist beispielsweise ein Gleichrichter, ein Wechselrichter, ein Umrichter oder ein Gleichspannungswandler zu verstehen. Derartige Halbleitermodule werden beispielsweise mittels einer planaren Aufbau- und Verbindungstechnik realisiert.

Die Offenlegungsschrift WO 2018/202439 A1 beschreibt eine elektronische Baugruppe mit einem Bauelement, welches zwischen einem ersten Substrat und einem zweiten Substrat gehalten ist. Erfindungsgemäß ist vorgesehen, dass ein Spalt zwischen dem ersten Substrat und dem Bauelement mit einem Durchgangsloch verbunden ist, so dass durch das Durchgangsloch hindurch beispielsweise ein Lotwerkstoff unter Ausnutzung von im Durchgangsloch und im Spalt wirkenden Kapillarkräften dosiert werden kann. Dabei erfolgt die Dosierung automatisch, da die Kapillarkräfte nur im Spalt wirken. Vorteilhaft lässt sich durch die automatische Dosierung des Lotwerkstoffs ein Toleranzausgleich bewerkstelligen, der aufgrund unterschiedlicher Spaltmaße notwendig werden kann.

Die Offenlegungsschrift WO 2019/015901 A1 beschreibt eine elektrische Baugruppe, die wenigstens ein elektronisches Schaltelement aufweist, das an seiner Unterseite und an seiner dieser gegenüberliegenden Oberseite elektrisch kontaktiert ist. Die elektrische Baugruppe weist zudem zwei einander gegenüberliegend an den elektrischen Kontaktierungen angeordnete Verdrahtungsträger auf. Diese Verdrahtungsträger sind jeweils wenigstens zum Teil aus einem dauerelastischen, elektrisch isolierenden, thermisch leitfähigen Material gebildet.

Bei einer derartigen planaren Aufbau- und Verbindungstechnik ist eine Integration von, insbesondere zusätzlichen, Wärmekapazitäten, durch den flachen Aufbau nur schwer umsetzbar. Derartige Wärmekapazitäten werden insbesondere bei hohen und kurzzeitigen Überlastanforderungen benötigt, um z.B. Chiptemperaturschwankungen klein zu halten. Ein Phasenwechselmaterial ist geeignet, derartige Temperaturschwankungen signifikant zu reduzieren. Ein Phasenwechselmaterial (auf Englisch "Phase Change Material", kurz PCM) ist bekanntlich ein Material, das sich durch eine hohe Schmelzenthalpie auszeichnet und damit in der Lage ist, beim Übergang vom festen in den flüssigen Zustand, welcher Phasenwechsel genannt wird, in erheblichem Umfang Wärmeenergie aufzunehmen.

Die Offenlegungsschrift DE 10 2014 213 545 A1 beschreibt ein Leistungshalbleitermodul, bei dem ein keramischer Verdrahtungsträger als Kühlkörper fungiert, indem mit dem keramischen Verdrahtungsträger ein Phasenwechselmaterial kombiniert ist. Das Phasenwechselmaterial ist in zur Oberfläche des Verdrahtungsträgers offene Kavitäten des Verdrahtungsträgers eingebracht, welche beispielsweise als offene Bohrungen, insbesondere als Sacklöcher, ausgeführt sind.

Durch die Öffnungen kann das Phasenwechselmaterial entweichen, was zu einer Reduzierung und schließlich zu einem Verlust des Phasenwechselmaterials führt. Ferner findet durch die Öffnungen eine beschleunigte Alterung des Phasenwechselmaterials statt. Durch Entweichen und Alterung des Phasenwechselmaterials wird die Wärmekapazität signifikant reduziert, was eine Zuverlässigkeit des Halbleitermoduls negativ beeinflusst.

Vor diesem Hintergrund besteht die Aufgabe der vorliegenden Erfindung darin, ein Halbleitermodul anzugeben, welches, im Vergleich zum Stand der Technik, eine höhere Zuverlässigkeit aufweist.

Die Aufgabe wird erfindungsgemäß durch ein Halbleitermodul mit zumindest einem Halbleiterelement, einem ersten Substrat und einem zweiten Substrat, wobei das zumindest eine Halbleiterelement auf einer ersten Seite flächig mit dem ersten Substrat und auf einer der ersten Seite abgewandten zweiten Seite flächig mit dem zweiten Substrat verbunden ist, wobei ein Phasenwechselmaterial in einer geschlossenen, insbesondere zusammenhängenden, Hohlraumstruktur des zweiten Substrats angeordnet ist und mit dem Halbleiterelement (4) in einer thermisch leitenden Verbindung steht.

Ferner wird die Aufgabe erfindungsgemäß gelöst durch ein Halbleitermodul mit zumindest einem Halbleiterelement, einem ersten Substrat und einem zweiten Substrat, wobei das zumindest eine Halbleiterelement auf einer ersten Seite flächig mit dem ersten Substrat und auf einer der ersten Seite abgewandten zweiten Seite flächig mit dem zweiten Substrat verbunden ist, wobei ein Phasenwechselmaterial, welches in eine Matrix eingebettet ist, im zweiten Substrat angeordnet ist und mit dem Halbleiterelement in einer thermisch leitenden Verbindung steht.

Überdies wird die Aufgabe erfindungsgemäß gelöst durch einen Stromrichter mit mindestens einem derartigen Halbleitermodul.

Darüber hinaus wird die Aufgabe erfindungsgemäß gelöst durch ein Verfahren zur Herstellung eines Halbleitermoduls mit zumindest einem Halbleiterelement, einem ersten Substrat und einem zweiten Substrat, wobei ein Phasenwechselmaterial in einer, insbesondere zusammenhängenden, Hohlraumstruktur des zweiten Substrats angeordnet wird, wobei die Hohlraumstruktur geschlossenen wird, wobei das zumindest eine Halbleiterelement auf einer ersten Seite flächig mit dem ersten Substrat und auf einer der ersten Seite abgewandten zweiten Seite flächig mit dem zweiten Substrat verbunden wird, sodass das Phasenwechselmaterial in einer thermisch leitenden Verbindung mit dem Halbleiterelement steht.

Darüber hinaus wird die Aufgabe erfindungsgemäß gelöst durch ein Verfahren zur Herstellung eines Halbleitermoduls mit zumindest einem Halbleiterelement, einem ersten Substrat und einem zweiten Substrat, wobei ein Phasenwechselmaterial in eine Matrix eingebettet und im zweiten Substrat angeordnet wird, wobei das zumindest eine Halbleiterelement auf einer ersten Seite flächig mit dem ersten Substrat und auf einer der ersten Seite abgewandten zweiten Seite flächig mit dem zweiten Substrat verbunden wird, sodass das Phasenwechselmaterial in einer thermisch leitenden Verbindung mit dem Halbleiterelement steht.

Die in Bezug auf das Halbleitermodul nachstehend angeführten Vorteile und bevorzugten Ausgestaltungen lassen sich sinngemäß auf den Stromrichter und das Herstellungsverfahren übertragen.

Der Erfindung liegt die Überlegung zugrunde, die Zuverlässigkeit eines Halbleitermoduls durch eine in ein Substrat integrierte Wärmesenke, welche ein Phasenwechselmaterial umfasst, zu erhöhen. Das Halbleitermodul weist zumindest ein Halbleiterelement, ein erstes Substrat und ein zweites Substrat auf, wobei das zumindest eine Halbleiterelement auf einer ersten Seite flächig mit dem ersten Substrat und auf einer der ersten Seite abgewandten zweiten Seite flächig mit dem zweiten Substrat verbunden ist. Ein derartiges Halbleiterelement ist beispielsweise als Transistor, als Diode oder als Logikbaustein ausgeführt. Insbesondere ist der Transistor als Insulated-Gate-Bipolar-Transistor (IGBT), Metalloxide-Semiconductor-Field-Effect-Transistor (MOSFET) oder Feldeffekttransistor ausgeführt. Beispielsweise weist ein derartiges Substrat zumindest eine dielektrische Materiallage und zumindest eine Metallisierung, auch Substratmetallisierung genannt, auf. Insbesondere erfolgt die flächige Kontaktierung des zumindest einen Halbleiterelements über eine elektrisch leitfähige Wärmeleitpaste oder über eine stoffschlüssige Verbindung auf der Metallisierung des jeweiligen Substrats. Das Phasenwechselmaterial ist im zweiten Substrat angeordnet. Unter einer Anordnung des Phasenwechselmaterials im Substrat ist zu verstehen, dass das Phasenwechselmaterial in einem Bereich des Substrats angeordnet ist, in dem zumindest eine dielektrische Materiallage und/oder zumindest eine Metallisierung ausgespart ist. Eine derartige Aussparung ist beispielsweise als eine Kavität ausgebildet. Durch eine derartige Integration des Phasenwechselmaterials im Substrat wird eine möglichst nahe Platzierung am Halbleiterelement ermöglicht, wobei eine thermisch leitende Verbindung des Phasenwechselmaterials mit dem Halbleiterelement hergestellt wird. Eine derartige thermische Kopplung erfolgt insbesondere über die Metallisierung des Substrats, welche beispielsweise Kupfer enthält und zahlreiche Vias umfasst.

Das Phasenwechselmaterial zeichnet sich beispielsweise durch eine hohe, insbesondere volumenspezifische, Schmelzenthalpie und eine hohe Zyklenfestigkeit aus. Im Halbleiterelement entstehende Verlustwärme, welche an das Phasenwechselmaterial übertragen wird, wird durch den Phasenwechsel zumindest teilweise im Phasenwechselmaterial gespeichert. Insbesondere weist das Phasenwechselmaterial eine Schmelztemperatur auf, welche unterhalb der Junction Temperatur des zumindest einen Halbleiterelements liegt. Beispielsweise enthält das Phasenwechselmaterial eine metallische Lötlegierung. Über die Legierungsbestandteile der Lötlegierung ist ein Schmelzpunkt oder Schmelzbereich einstellbar.

Um zu verhindern, dass das Phasenwechselmaterial entweicht, wird es in einer geschlossenen, insbesondere zusammenhängenden, Hohlraumstruktur angeordnet. Eine derartige geschlossene Hohlraumstruktur ist beispielsweise eine Kavität, welche, insbesondere fluiddicht, verschlossen ist. Durch die geschlossenen, insbesondere zusammenhängenden, Hohlraumstruktur wird ein Entweichen des Phasenwechselmaterials, insbesondere ein Ausgasen von flüchtigen Bestandteilen, verhindert und dessen Alterung verlangsamt, sodass die Wärmekapazität über einen verlängerten Zeitraum erhalten bleibt, sodass eine Zuverlässigkeit des Halbleitermoduls verbessert wird.

Um zu verhindern, dass das Phasenwechselmaterial entweicht, ist das Phasenwechselmaterial alternativ in einer Matrix eingebettet. Beispielsweise wird als Matrix ein Kleber oder ein Polymer, insbesondere ein Epoxymaterial oder Silikon, verwendet, dessen Temperaturstabilität nach seiner Aushärtung über der Schmelztemperatur des Phasenwechselmaterials liegt. Durch die Füllung der Matrix mit dem Phasenwechselmaterial wird dieses fixiert, wodurch ein Entweichen des Phasenwechselmaterials verhindert und dessen Alterung verlangsamt wird, sodass die Wärmekapazität über einen verlängerten Zeitraum erhalten bleibt, sodass eine Zuverlässigkeit des Halbleitermoduls verbessert wird.

Eine weitere Ausführungsform sieht vor, dass das Phasenwechselmaterial eine Schmelztemperatur im Bereich von 90°C bis 175°C aufweist. Beispielsweise enthält das Phasenwechselmaterial 30 Dimethylterephthalat, D-Mannitol, Adipinsäure, Kaliumthiocyanat, Hydrochinon oder Benzanilid. Die Schmelztemperatur liegt unterhalb der Junction Temperatur des Halbleiterelements, welche beispielsweise bei knapp über 175°C liegt. Über das Phasenwechselmaterial ist ein Schmelzpunkt oder Schmelzbereich einstellbar, sodass, insbesondere anwendungsspezifisch, effizient Wärmeenergie aufgenommen wird.

Eine weitere Ausführungsform sieht vor, dass das Halbleiterelement stoffschlüssig mit einer oberen Metallisierung des ersten Substrats und/oder mit einer Substratmetallisierung des zweiten Substrats verbunden ist. Eine derartige stoffschlüssige Verbindung ist beispielsweise als eine Löt- oder Sinterverbindung ausgeführt, was zu einer verbesserten thermischen Anbindung führt.

Eine weitere Ausführungsform sieht vor, dass das Phasenwechselmaterial über die Substratmetallisierung des zweiten Substrats in einer thermisch leitenden Verbindung mit dem Halbleiterelement steht. Insbesondere enthält die Substratmetallisierung Kupfer und umfasst beispielsweise zahlreiche Vias. Durch die thermische Kopplung über die Substratmetallisierung wird eine optimale thermischen Anbindung erreicht.

Eine weitere Ausführungsform sieht vor, dass das Phasenwechselmaterial in zumindest einer Kavität des zweiten Substrats angeordnet ist, welche, in einer thermisch leitenden Verbindung mit dem Halbleiterelement steht. Eine derartige Kavität ist einfach, beispielsweise durch Fräsen, realisierbar. Ferner ist eine Kavität flexibel im Layout positionierbar, sodass das Phasenwechselmaterial chipnah platzierbar ist, was für einen optimierten Wärmeübergang sorgt.

Eine weitere Ausführungsform sieht vor, dass die Kavität eine, insbesondere umlaufende, Kantenmetallisierung aufweist. Die umlaufende Kantenmetallisierung wird insbesondere galvanisch hergestellt und enthält beispielsweise Kupfer, was für eine zusätzliche Verbesserung der thermischen Anbindung sorgt.

Eine weitere Ausführungsform sieht vor, dass die Kavität metallische Rippen aufweist, welche in einer thermisch leitenden Verbindung mit dem Phasenwechselmaterial stehen. Beispielsweise werden die metallischen Rippen galvanisch oder additiv, insbesondere aus Kupfer, hergestellt. Die Rippen sind beispielsweise quader- oder zylinderförmig ausgeführt und vergrößern eine Oberfläche innerhalb der Kavität zur thermischen Kontaktierung des Phasenwechselmaterials.

Eine weitere Ausführungsform sieht vor, dass die geschlossene, insbesondere zusammenhängende, Hohlraumstruktur des zweiten Substrats eine Kavität mit einer Verschlussvorrichtung umfasst. Eine derartige Verschlussvorrichtung ist beispielsweise aus einem metallischen Werkstoff hergestellt und verschließt die Kavität insbesondere fluiddicht. Ein derartiger fluiddichter Verschluss ist beispielsweise durch eine stoffschlüssige Verbindung der Verschlussvorrichtung mit der Metallisierung des Substrats herstellbar. Alternativ wird eine derartige Verschlussvorrichtung additiv aufgebracht. Ein derartiger, insbesondere fluiddichter, Verschluss ist einfach und kostengünstig herstellbar.

Eine weitere Ausführungsform sieht vor, dass die geschlossene, insbesondere zusammenhängende, Hohlraumstruktur zumindest eine zusätzliche Ausgleichsstruktur umfasst, welche zur Kompensation von Volumenänderungen des Phasenwechselmaterials vorgesehen ist. Eine derartige Ausgleichsstruktur ist beispielsweise als eine, insbesondere luftgefüllte, Ausnehmung ausgeführt, in welcher sich das Phasenwechselmaterial bei einer Volumenänderung ausdehnen kann. Eine derartige Ausgleichsstruktur ist einfach und kostengünstig herstellbar.

Im Folgenden wird die Erfindung anhand der in den Figuren dargestellten Ausführungsbeispiele näher beschrieben und erläutert.

Es zeigen:
- FIG 1: eine schematische Darstellung einer ersten Ausgestaltung eines Halbleitermoduls im Querschnitt,
- FIG 2: eine schematische Darstellung einer zweiten Ausgestaltung eines Halbleitermoduls im Querschnitt,
- FIG 3: eine schematische Darstellung einer dritten Ausgestaltung eines Halbleitermoduls im Querschnitt,
- FIG 4: eine schematische Darstellung eines Stromrichters mit einem Halbleitermodul und

- FIG 5: eine schematische Darstellung eines Verfahrens zur Herstellung eines Halbleitermoduls.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

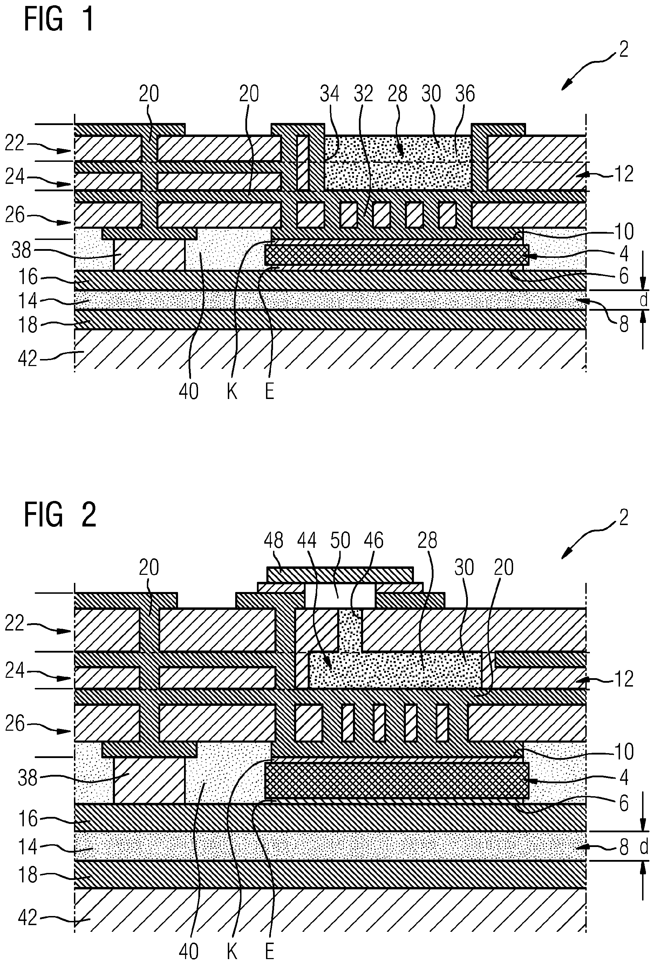

FIG 1 zeigt eine schematische Darstellung einer ersten Ausgestaltung eines Halbleitermoduls 2 im Querschnitt. Das Halbleitermodul 2 umfasst mindestens ein Halbleiterelement 4, das auf einer ersten Seite 6 flächig mit einem ersten Substrat 8 und auf einer der ersten Seite 6 abgewandten zweiten Seite 10 flächig mit einem zweiten Substrat 12 verbunden ist. Die flächige Kontaktierung des Halbleiterelements 4 mit dem ersten Substrat 8 und dem zweiten Substrat 12 wird beispielsweise durch eine stoffschlüssige Verbindung, insbesondere eine Löt- oder Sinterverbindung, hergestellt, wobei durch die stoffschlüssige Verbindung des Halbleiterelements 4 mit den Substraten 8, 12 jeweils, neben der elektrischen Verbindung, eine thermische Kopplung hergestellt wird.

Das Halbleiterelement 4 ist exemplarisch als Insulated-Gate-Bipolar-Transistor (IGBT) ausgeführt, kann aber auch als Metalloxide-Semiconductor-Field-Effect-Transistor (MOSFET), als Feldeffekttransistor, als Diode, als Logikbaustein, insbesondere als Field Programmable Gate Array (FPGA) oder als ein anderer Halbleiter ausgeführt sein. Insbesondere weist das Halbleiterelement 4 eine Fläche von mindestens 10 mm2 auf. Beispielsweise ist das als IGBT ausgeführte Halbleiterelement 4 über einen Emitterkontakt E mit dem ersten Substrat 8 und über einen Kollektorkontakt K mit dem zweiten Substrat 12 verbunden. Ein Gatekontakt des in FIG 1 dargestellten IGBTs ist aus Gründen der Übersichtlichkeit nicht dargestellt.

Das erste Substrat 8 umfasst eine dielektrische Materiallage 14, die einen keramischen Werkstoff, beispielsweise Aluminiumnitrid oder Aluminiumoxid, oder einen organischen Werkstoff, beispielsweise einem Polyamid enthält und eine Dicke d von 25 µm bis 650 µm, insbesondere 50 µm bis 250 µm, aufweist. Darüber hinaus weist das erste Substrat 8 auf einer dem Halbleiterelement 4 zugewandten Seite eine obere Metallisierung 16 und auf einer dem Halbleiterelement 4 abgewandten Seite eine untere Metallisierung 18 auf, wobei die obere Metallisierung 16 und die untere Metallisierung 18 beispielsweise aus Kupfer hergestellt sind. Insbesondere ist das erste Substrat 8 als Direct Bonded Copper (DCB) ausgeführt.

Das zweite Substrat 12 ist als mehrlagige, beispielsweise dreilagige, Leiterplatte, auch Printed Circuit Board (PCB) genannt, ausgeführt, wobei die Lagen 22, 24, 26 der Leiterplatte eine strukturierte Substratmetallisierung 20 aufweisen, wobei das Halbleiterelement 4 stoffschlüssig mit der Substratmetallisierung 20 des zweiten Substrats 12 verbunden ist. Ferner weist das zweite Substrat 12 eine, insbesondere offene, Kavität 28 auf, in welcher ein Phasenwechselmaterial 30 angeordnet ist, welches mit dem Halbleiterelement 4 in einer thermisch leitenden Verbindung steht. Beispielhaft ist die Kavität 28 in der ersten Lage 22 und in der zweiten Lage 24 eingefräst, wobei die dritte Lage 26 durch eine beidseitige Substratmetallisierung 20 und zahlreiche Vias 32 eine sehr gute thermische Anbindung des Halbleiterelements 4 an das Phasenwechselmaterial 30 herstellt. Die Thermische Anbindung des Phasenwechselmaterials 30 wird durch eine Kantenmetallisierung 34 der Kavität 28 optimiert.

Das Phasenwechselmaterial 30 zeichnet sich durch eine hohe, insbesondere volumenspezifische, Schmelzenthalpie aus und ist damit in der Lage, beim Übergang von einem festen in einen flüssigen Zustand, welcher Phasenwechsel genannt wird, in erheblichem Umfang Wärmeenergie aufzunehmen. Insbesondere weist das Phasenwechselmaterial 30 eine hohe Zyklenfestigkeit auf. Im Halbleiterelement 4 entstehende Verlustwärme, welche an das Phasenwechselmaterial 30 übertragen wird, wird durch den Phasenwechsel zumindest teilweise im Phasenwechselmaterial 30 gespeichert. Das Phasenwechselmaterial 30 weist eine Schmelztemperatur auf, welche unterhalb der Junction Temperatur des Halbleiterelements 4 liegt. Insbesondere weist das Phasenwechselmaterial 30 eine Schmelztemperatur im Bereich von 90°C bis 175°C auf. Beispielsweise enthält das Phasenwechselmaterial 30 Dimethylterephthalat, D-Mannitol, Adipinsäure, Kaliumthiocyanat, Hydrochinon oder Benzanilid. Alternativ enthält das Phasenwechselmaterial eine metallische Lötlegierung. Über die Legierungsbestandteile der Lötlegierung ist ein Schmelzpunkt oder Schmelzbereich einstellbar. Die von der Lötlegierung benetzten Metallflächen können eine Schutzbeschichtung aufweisen, die ein Ablegieren der benetzten Metallflächen verhindert. Das Phasenwechselmaterial 30 ist zur Fixierung in der, insbesondere offenen, Kavität 28 in eine Matrix 36 eingebettet. Beispielsweise wird als Matrix 36 ein Kleber oder ein Polymer, insbesondere ein Epoxymaterial oder Silikon, verwendet, dessen Temperaturstabilität nach seiner Aushärtung über der Schmelztemperatur des Phasenwechselmaterials 30 liegt. Die Matrix 36 wird beispielsweise mit Partikeln des Phasenwechselmaterials 30 gefüllt.

Ferner ist zwischen dem ersten Substrat 8 und dem zweiten Substrat 12 ein metallisches Abstandshalteelement 38 angeordnet, welches den Emitterkontakt E des Halbleiterelements 4 elektrisch leitend mit dem zweiten Substrat 12 verbindet. Das metallische Abstandshalteelement 38, welches auch Umsteiger genannt wird, ist beispielsweise aus Kupfer, Aluminium oder einer deren Legierungen hergestellt. Darüber hinaus ist das Halbleiterelement 4 in einem Vergussraum 40 zwischen dem ersten Substrat 8 und dem zweiten Substrat 12 angeordnet, welcher, insbesondere vollständig, durch eine Vergussmasse befüllt ist. Das erste Substrat 8 ist überdies, insbesondere stoffschlüssig, mit einer metallischen Grundplatte 42 verbunden, welche beispielsweise als Kühlkörper ausgeführt ist.

FIG 2 zeigt eine schematische Darstellung einer ersten Ausgestaltung eines Halbleitermoduls 2 im Querschnitt. Das Phasenwechselmaterial 30 ist in einer geschlossenen zusammenhängenden Hohlraumstruktur 44 des zweiten Substrats 12 angeordnet. Durch die geschlossene Hohlraumstruktur 44 muss das Phasenwechselmaterial 30 nicht in eine Matrix 36 eingebettet sein. Die zusammenhängende Hohlraumstruktur 44 umfasst eine Kavität 28, welche in der zweiten Lage 24 des zweiten Substrats 12 angeordnet ist und beidseitig durch die erste Lage 22 und die dritte Lage 26 verschlossen wird. Die zusammenhängende Hohlraumstruktur 44, welche ein geschlossenes Reservoir für das Phasenwechselmaterial 30 ausbildet, umfasst eine Einfüllöffnung 46 für das Phasenwechselmaterial 30, welche durch die erste Lage 22 des zweiten Substrats 12 verlaufend angeordnet ist. Die Einfüllöffnung 46 ist von einer Verschlussvorrichtung 48, insbesondere fluiddicht, verschlossen. Beispielhaft ist die, insbesondere metallische Verschlussvorrichtung 48 stoffschlüssig mit der Substratmetallisierung 20 verbunden, wobei eine Ausgleichsstruktur 50 ausgebildet ist, welche zur Kompensation von Volumenänderung des Phasenwechselmaterials 30 vorgesehen ist. Die weitere Ausgestaltung des Halbleitermoduls 2 in FIG 2 entspricht der in FIG 1.

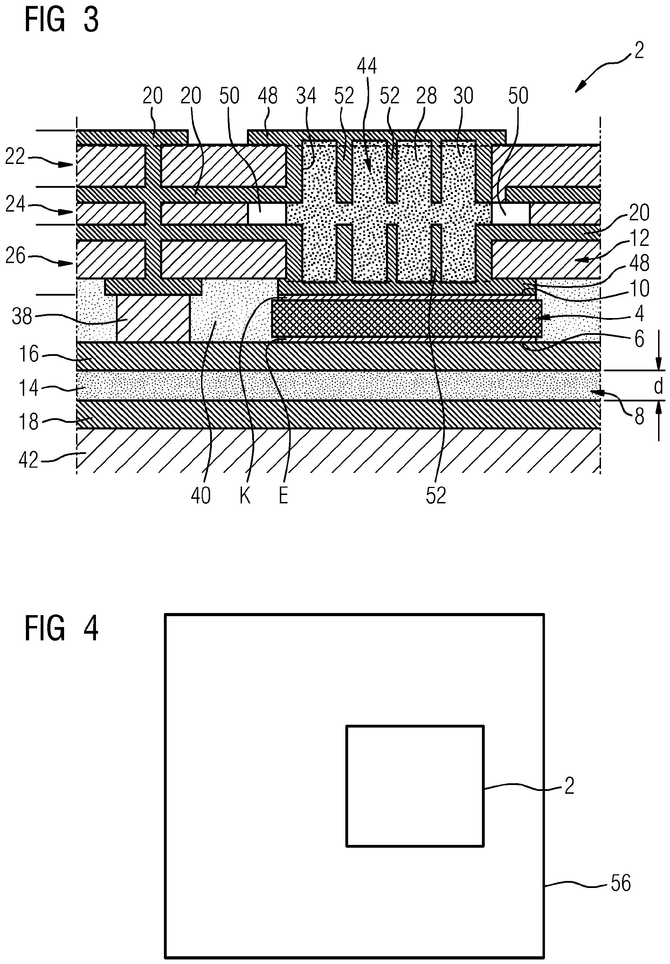

FIG 3 zeigt eine schematische Darstellung einer dritten Ausgestaltung eines Halbleitermoduls 2 im Querschnitt. Die geschlossene Hohlraumstruktur 44 umfasst eine Kavität 28, welche sich über alle Lagen 22, 24, 26 des zweiten Substrats 12 erstreckt. Ferner weist die Kavität 28 metallische Rippen 52 auf, welche in einer thermisch leitenden Verbindung mit dem Phasenwechselmaterial 30 stehen. Durch die Rippen 52 wird eine Vergrößerung der Kontaktfläche erreicht, was zu einer verbesserten thermischen Kontaktierung des Phasenwechselmaterials 30 führt. Die Hohlraumstruktur 44 ist zusammenhängend ausgeführt und wird durch beidseitig angeordnete metallische Verschlussvorrichtungen 48, welche beispielsweise durch Metallisieren des verfestigten Phasenwechselmaterials 30 hergestellt sind, geschlossen. Das Phasenwechselmaterial 30 ist, insbesondere unmittelbar, über eine metallische Verschlussvorrichtung 48 mit dem Halbleiterelement 4 verbunden. Insbesondere sind die beidseitig angeordneten metallischen Verschlussvorrichtungen 48 Teil der Substratmetallisierung 20 des zweiten Substrats 12. Ferner weist die geschlossene zusammenhängende Hohlraumstruktur 44 Ausgleichsstrukturen 50 auf, welche im Bereich der zweiten Lage 24 angeordnet sind und zur Kompensation von Volumenänderungen des Phasenwechselmaterials 30 vorgesehen sind. Die weitere Ausgestaltung des Halbleitermoduls 2 in FIG 3 entspricht der in FIG 2.

FIG 4 zeigt eine schematische Darstellung eines Stromrichters 54 mit einem Halbleitermodul 2. Der Stromrichter 54 kann mehr als ein Halbleitermodul 2 umfassen.

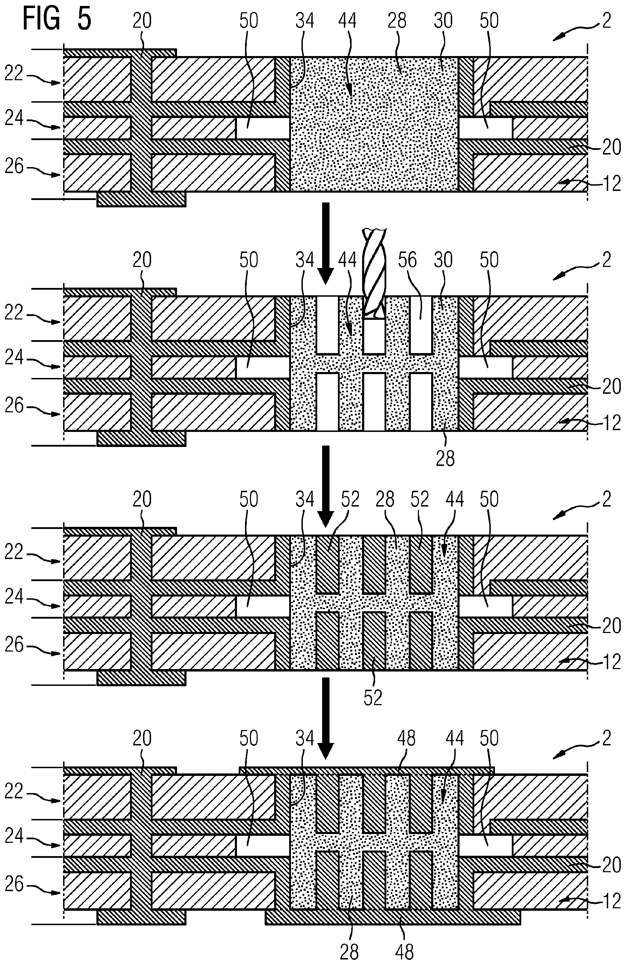

FIG 5 zeigt eine schematische Darstellung eines Verfahrens zur Herstellung eines Halbleitermoduls 2. Das zweite Substrat 12 weist eine Kavität 28 auf, welche sich über alle Lagen 22, 24, 26 des zweiten Substrats 12 erstreckt und eine Hohlraumstruktur 44 bildet. Das Phasenwechselmaterial 30 wird in die Hohlraumstruktur 44 eingebracht und dort verfestigt, wobei im Bereich der zweiten Lage 24 Ausgleichsstrukturen 50 ausgebildet werden. Daraufhin werden in das verfestigte Phasenwechselmaterial 30, beispielsweise durch Bohren oder Fräsen, Ausnehmungen eingefügt, in welchen in einem darauffolgenden Schritt metallische Rippen 52 eingesetzt werden. Alternativ werden die Rippen 52 durch, beispielsweise galvanische oder additive, Metallisierung hergestellt. Anschließend wird die mit dem Phasenwechselmaterial 30 gefüllte Hohlraumstruktur 44 durch Verschlussvorrichtungen 48 geschlossen, welche durch Metallisieren hergestellt werden. Insbesondere wird das verfestigte Phasenwechselmaterial 30 beidseitig metallisiert. Dabei werden die Rippen 52 durch Metallisieren elektrisch und thermisch leitend mit der Substratmetallisierung 20 des zweiten Substrats 12 verbunden. Daraufhin wird, wie in FIG 3 abgebildet, das Halbleiterelement 4 auf einer ersten Seite 6 flächig mit dem ersten Substrat 8 und auf einer der ersten Seite 6 abgewandten zweiten Seite 10 flächig mit dem zweiten Substrat 12 verbunden, sodass das Phasenwechselmaterial 30 in einer thermisch leitenden Verbindung mit dem Halbleiterelement 4 steht. Die weitere Ausgestaltung des Halbleitermoduls 2 in FIG 5 entspricht der in FIG 3.

Zusammenfassend betrifft die Erfindung ein Halbleitermodul 2 mit zumindest einem Halbleiterelement 4, einem ersten Substrat 6 und einem zweiten Substrat 12. Um, im Vergleich zum Stand der Technik, eine höhere Zuverlässigkeit zu erreichen, wird vorgeschlagen, dass das zumindest eine Halbleiterelement 4 auf einer ersten Seite 6 flächig mit dem ersten Substrat 8 und auf einer der ersten Seite 6 abgewandten zweiten Seite 10 flächig mit dem zweiten Substrat 12 verbunden ist, wobei ein Phasenwechselmaterial 30 in einer geschlossenen, insbesondere zusammenhängenden, Hohlraumstruktur 44 des zweiten Substrats 12 angeordnet ist und mit dem Halbleiterelement 4 in einer thermisch leitenden Verbindung steht.

## Patentansprüche

1. Halbleitermodul (2) mit zumindest einem Halbleiterelement (4), einem ersten Substrat (8) und einem zweiten Substrat (12),
wobei das zumindest eine Halbleiterelement (4) auf einer ersten Seite (6) flächig mit dem ersten Substrat (8) und auf einer der ersten Seite (6) abgewandten zweiten Seite (10) flächig mit dem zweiten Substrat (12) verbunden ist,
wobei ein Phasenwechselmaterial (30) in einer geschlossenen, insbesondere zusammenhängenden, Hohlraumstruktur (44) des zweiten Substrats (12) angeordnet ist und
mit dem Halbleiterelement (4) in einer thermisch leitenden Verbindung steht.

2. Halbleitermodul (2) mit zumindest einem Halbleiterelement (4), einem ersten Substrat (8) und einem zweiten Substrat (12),
wobei das zumindest eine Halbleiterelement (4) auf einer ersten Seite (6) flächig mit dem ersten Substrat (8) und auf einer der ersten Seite (6) abgewandten zweiten Seite (10) flächig mit dem zweiten Substrat (12) verbunden ist,
wobei ein Phasenwechselmaterial (30), welches in eine Matrix (36) eingebettet ist, im zweiten Substrat (12) angeordnet ist und mit dem Halbleiterelement (4) in einer thermisch leitenden Verbindung steht.

3. Halbleitermodul (2) nach einem der Ansprüche 1 oder 2,
wobei das Phasenwechselmaterial (30) eine Schmelztemperatur im Bereich von 90°C bis 175°C aufweist.

4. Halbleitermodul (2) nach einem der vorherigen Ansprüche,
wobei das Halbleiterelement (4) stoffschlüssig mit einer oberen Metallisierung (16) des ersten Substrats (8) und/oder mit einer Substratmetallisierung (20) des zweiten Substrats (12) verbunden ist.

5. Halbleitermodul (2) nach Anspruch 4,
wobei das Phasenwechselmaterial (30) über die Substratmetallisierung (20) des zweiten Substrats (12) in einer thermisch leitenden Verbindung mit dem Halbleiterelement (4) steht.

6. Halbleitermodul (2) nach einem der vorherigen Ansprüche,
wobei das Phasenwechselmaterial (30) in zumindest einer Kavität (28) des zweiten Substrats (12) angeordnet ist, welche, in einer thermisch leitenden Verbindung mit dem Halbleiterelement (4) steht.

7. Halbleitermodul (2) nach Anspruch 6,
wobei die Kavität (28) eine, insbesondere umlaufende, Kantenmetallisierung (34) aufweist.

8. Halbleitermodul (2) nach einem der vorherigen Ansprüche,
wobei die Kavität (28) metallische Rippen (52) aufweist, welche in einer thermisch leitenden Verbindung mit dem Phasenwechselmaterial (30) stehen.

9. Halbleitermodul (2) nach Anspruch 1,
wobei die geschlossene, insbesondere zusammenhängende, Hohlraumstruktur (44) des zweiten Substrats (12) eine Kavität (28) mit einer Verschlussvorrichtung (48) umfasst.

10. Halbleitermodul (2) nach einem der Ansprüche 1 oder 9,
wobei die geschlossene, insbesondere zusammenhängende, Hohlraumstruktur (44) zumindest eine zusätzliche Ausgleichsstruktur (50) umfasst, welche zur Kompensation von Volumenänderungen des Phasenwechselmaterials (30) vorgesehen ist.

11. Stromrichter (54) mit mindestens einem Halbleitermodul (2) nach einem der vorherigen Ansprüche.

12. Verfahren zur Herstellung eines Halbleitermoduls mit zumindest einem Halbleiterelement (4), einem ersten Substrat (8) und einem zweiten Substrat (12),
wobei ein Phasenwechselmaterial (30) in einer, insbesondere zusammenhängenden, Hohlraumstruktur (44) des zweiten Substrats (12) angeordnet wird,
wobei die Hohlraumstruktur (44) geschlossenen wird,
wobei das zumindest eine Halbleiterelement (4) auf einer ersten Seite (6) flächig mit dem ersten Substrat (8) und auf einer der ersten Seite (6) abgewandten zweiten Seite (10) flächig mit dem zweiten Substrat (12) verbunden wird,
sodass das Phasenwechselmaterial (30) in einer thermisch leitenden Verbindung mit dem Halbleiterelement (4) steht.

13. Verfahren nach Anspruch 12,
wobei das Phasenwechselmaterial (30) in der Hohlraumstruktur (44) verfestigt wird,
wobei die Hohlraumstruktur (44) durch Metallisieren des verfestigten Phasenwechselmaterials (30), insbesondere beidseitig, geschlossenen wird.

14. Verfahren nach Anspruch 13,
wobei in das verfestigte Phasenwechselmaterial (30) Rippen (52) eingesetzt werden,
wobei die Rippen (52) durch Metallisieren mit der Substratmetallisierung (20) des zweiten Substrats (12) verbunden werden.

15. Verfahren zur Herstellung eines Halbleitermoduls mit zumindest einem Halbleiterelement (4), einem ersten Substrat (8) und einem zweiten Substrat (12),
wobei ein Phasenwechselmaterial (30) in eine Matrix (36) eingebettet und im zweiten Substrat (12) angeordnet wird,
wobei das zumindest eine Halbleiterelement (4) auf einer ersten Seite (6) flächig mit dem ersten Substrat (8) und auf einer der ersten Seite (6) abgewandten zweiten Seite (10) flächig mit dem zweiten Substrat (12) verbunden wird,
sodass das Phasenwechselmaterial (30) in einer thermisch leitenden Verbindung mit dem Halbleiterelement (4) steht.
